# FASCICULE DE BREVET EUROPEEN

(11) **EP 0 351 315 B1**
(45) Date de publication et mention de la délivrance du brevet: **31.03.1993**
(21) Numéro de dépôt: 89401998.3
(22) Date de dépôt: 12.07.1989
(51) Int. Cl.: G06F 1/16, H05K 7/14

(54) **Système de connexion électrique d'ordinateur**
Elektrisches Verbindungssystem für Rechner
Electrical connection system for a computer

(30) Priorité: 13.07.1988 FR 8809590
(43) Date de publication de la demande: 17.01.1990
(73) Titulaire: BULL S.A., 92800 Puteaux (FR)
(72) Inventeur: Cesar, Charles, F-38400 St. Martin D'Hères (FR)
(74) Mandataire: Debay, Yves

(56) Documents cités:
- EP-A- 0 189 796
- GB-A- 2 122 424
- US-A- 2 602 842

## Description

La présente invention concerne un système de connexion électrique d'ordinateur. Elle trouve application dans le domaine de la fabrication d'ordinateurs de tous genres depuis les stations de travail jusqu'aux ordinateurs spécialisés comme ceux contenant des "PABX".

Dans l'art antérieur, on connait des ordinateurs qui comportent des périphériques intégrés au chassis de l'ordinateur hôte. De tels périphériques sont fréquemment des mémoires de masses magnétiques ou encore des lecteurs de badges ou de cartes à puce.

Le brevet US 4 888 549 enseigne la connexion d'un périphérique sur un testeur. Ce document n'enseigne pas du tout l'utilisation d'un boîtier et encore moins la fixation d'un connecteur extérieur sur le boîtier, ce connecteur étant relié aux connecteurs secondaires par des tresses en fils souples.

La maintenance de tels ordinateurs oblige le technicien à démonter un tel périphérique intégré.

Une première solution naturelle est de prévoir un chassis d'ordinateur hôte en deux parties dont l'une est démontable de la première et permet de dégager l'accès au périphérique défaillant.

Les inconvénients d'une telle solution sont notamment que l'alimentation de l'ordinateur doit être coupée à cause de l'interruption des masses du chassis provoquée par son ouverture. Le traitement informatique en cours doit donc être interrompu ce qui écarte la solution pour les applications de contrôle de processus industriels ou de communications par exemple.

Une solution à ce problème seulement possible sur de gros systèmes et peu satisfaisante consiste à prévoir une unité de remplacement qui est automatiquement commutée à la place de l'unité manquante. Mais une telle solution est couteuse et les ressources d'adressage ne sont pas convenablement utilisées.

Dans un certain nombre d'applications est apparu le besoin d'une réparation ne nécessitant pas l'arrêt de l'ordinateur. Un tel concept conduit à la constitution d'appareils composants un ordinateur complet à partir d'unités dites "Change and Repair Units" (CRUs). Une telle solution pose des problèmes mécaniques difficiles à résoudre quand la standardisation doit être respectée.

En effet, il est hors de question de prévoir des périphériques spécifiques adaptables au concept CRU dès que la production de masse ou standardisée doit être entreprise. Hors si les dimensions des périphériques (format slim line 5 pouces 1/4 ou 3 pouces et demi) sont bien admis dans la profession, il n'en est pas de même des connecteurs qui permettent de relier électriquement le périphérique intégrable aux circuits d'interface de l'ordinateur hôte.

Dans l'art antérieur, l'homme de métier sait trouver des solutions à base de circuits imprimés pour relier deux connecteurs en particulier pour adapter un connecteur de brochage d'un premier genre à un connecteur de brochage d'un second genre. Une telle solution est particulièrement satisfaisante au point de vue de la fiabilité et de la facilité d'industriualisation. Mais, elle est inadaptée au cas où il faut réunir des connecteurs à des endroits qui ne sont pas déterminés et fixes.

L'invention apporte une solution à ce problème. En effet, elle concerne un système de connexion électrique d'ordinateur, en vue de disposer un périphérique de manière amovible à l'intérieur de l'ordinateur, caractérisé en ce qu'il comporte :
- un boitier qui contient le périphérique proprement dit, ledit boitier étant destiné à l'insertion dans le chassis de l'ordinateur hôte,
- un premier connecteur fixé extérieurement au boitier dans une position répondant aux normes de connexion des périphériques aux ordinateurs hôtes,
- au moins deux connecteurs secondaires logés dans un espace intérieur au boitier et électriquement connectés au premier connecteur, chaque connecteur ayant une fonction déterminée comme la connexion des signaux de données ou celle des signaux de commande du périphérique,

ces connecteurs secondaires pouvant être fixés mécaniquement en des lieux dépendant des connecteurs propres au périphérique, les connecteurs secondaires (3,4,5) étant reliés au premier connecteur (9) par des tresses en fils souples dont les longueurs sont adaptées à la localisation des connecteurs du périphérique intégré inséré dans le boîtier.

L'invention permet aussi de résoudre les problèmes qu'entrainent une telle technologie en proposant des moyens de blindage électomagnétique et de refroidissement.

Elle s'adapte aussi au cas de connexions filaires.

D'autres caractéristiques et avantages de la présente invention seront mieux compris à l'aide de la description et des figures qui sont :
- la figure 1 : un schéma représentant un mode de réalisation de l'invention,
- la figure 2 : un schéma d'un autre mode de réalisation selon l'invention.

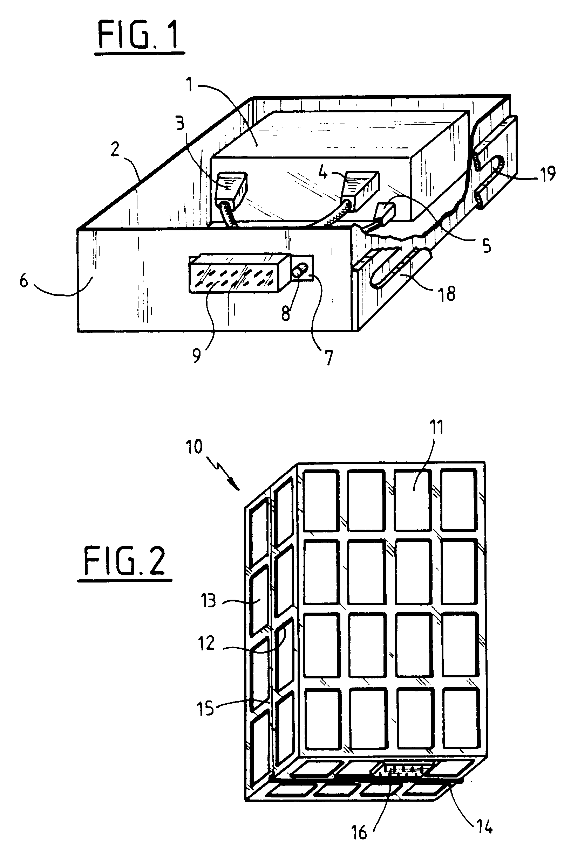

A la figure 1, on a représenté un mode de réalisation selon l'invention. Le périphérique 1 est contenu dans un boitier 2. La face arrière de périphérique possède trois connecteurs 3, 4, 5 réservés respectivement pour les données, les alimentations électriques et les signaux de commande du périphérique 1. La face arrière 6 du boitier 2 porte un connecteur 9 au standard de connection comme un connecteur DIN 41612 fixé au boitier 2 par un système d'oreilles comme 7 et de vis 8.

Les trois connecteurs secondaires sont électriquement reliés au connecteur 9 standard par trois tresses distinctes de fils électriques isolés. La longueur des tresses est calculée pour tout type de périphérique en fonction de la localisation de ses propres connecteurs qui varie d'un type de périphérique à l'autre.

A la figure 1, le boitier qui contient le périphérique 1 comporte des moyens d'insertion dans le chassis d'un ordinateur hôte. Ces moyens, dans un mode de réalisation préférée, sont constitués par deux glissières comme la glissière 18 sur lesquelles sont percées des rails comme le rail 19 à l'intérieur duquel vient s'engager un élément de roulement comme une roulette solidaire du chassis de l'ordinateur hôte.

A la figure 2, on a représenté un autre mode de réalisation selon l'invention. Le boitier 10 est constitué en un matériau conducteur comme une tôle d'acier. Le boitier 10 est configuré en deux moitiés qui pivotent sur une charnière 14 disposée en face arrière du boitier, c'est à dire la face qui entre la première dans le logement d'insertion prévu dans l'ordinateur hôte.

L'ensemble constitue une cage de protection à la fois contre les rayonnements électromagnétiques de l'extérieur du boitier que pour bloquer les émissions parasites du périphérique qu'il contient.

Afin de permettre une ventilation efficace du périphérique, le boitier est percé d'ouvertures dont le nombre et la surface sont calculées en fonction du débit d'air de refroidissement traversant le compartiment d'insertion et de la puissance dissipée par le périphérique interne.

Le bord 15 en recouvrement des deux moitiés du boitier 10 permet de protéger les fuites de rayonnement en étant constitué par un recouvrement tôle sur tôle des deux moitiés. Ce recouvrement est composé par un pliage des tôles à cet endroit ce qui présente aussi l'avantage d'un renforcement de la rigidité mécanique de l'ensemble.

A la figure 2, le connecteur 16 est destiné à venir s'engager dans le connecteur fixe correspondant installé dans le logement d'insertion de l'ordinateur hôte. De cette façon, l'ordinateur hôte n'est plus dépendant de la connectique de périphérique, la conversion étant assurée par le boitier 10. On peut ainsi s'approvisionner en tant que constructeur chez des fabricants différents de périphériques intégrables et les connecter toujours sur des connecteurs standards.

Dans un mode de réalisation, le boitier est muni de moyens de préhension qui facilitent la maintenance et de détrompeurs mécaniques pour éviter que le boitier soit monté d'une façon erronnée. A cet effet on place une poignée sur la face avant du boitier, celle-ci comportant aussi un dégagement pour le passage d'une disquette dans le cas d'un lecteur de disquettes ou d'une cartouche dans le cas d'un lecteur de cartouches de bandes magnétiques.

## Revendications

1. Système de connexion électrique d'ordinateur, en vue de disposer de manière amovible un périphérique à l'intérieur de l'ordinateur et de le relier à l'ordinateur par des connecteurs, caractérisé en ce qu'il comporte :
- un boîtier (2) qui contient le périphérique proprement dit (1),
- un premier connecteur (9) fixé extérieurement au boîtier dans une position répondant aux normes de connexion des périphériques aux ordinateurs hôtes,
- au moins deux connecteurs secondaires (3,4,5) logés dans un espace intérieur au boîtier et électriquement connectés au premier connecteur (9), chaque connecteur ayant une fonction déterminée comme la connexion des signaux de données ou celle des signaux de commande du périphérique, ces connecteurs secondaires (3,4,5) pouvant être fixés mécaniquement en des lieux dépendant des connecteurs propres au périphérique (1), les connecteurs secondaires (3,4,5) étant reliés au premier connecteur (9) par des tresses en fils souples dont les longueurs sont adaptées à la localisation des connecteurs du périphérique intégré inséré dans le boîtier.

2. Système de connexion électrique selon la revendication 1 caractérisé en ce que le boîtier comporte des moyens de protection contre les rayonnements électromagnétiques (12).

3. Système de connexion électrique selon la revendication 1 ou 2, caractérisé en ce qu'il comporte des moyens de refroidissement (11) du périphérique intégré.

4. Système de connexion électrique selon la revendication 1 ou 3, caractérisé en ce que le boîtier (2) est formé en deux moitiés conductrice, comportant des ouvertures de refroidissement des équipements qu'il contient, chaque moitié ayant un bord en recouvrement, une charnière disposée sur un panneau arrière du dit boîtier pour pivoter une des dites moitié afin de loger l'équipement périphérique.

5. Système de connexion électrique selon la revendication 1 ou 4, caractérisé en ce qu'il comporte aussi des moyens de préhension de façon à faciliter la maintenance du système informatique comme une poignée disposée en face avant du périphérique installé.

6. Système de connexion électrique selon la revendication 1 ou 4, caractérisé en ce qu'il comporte aussi des moyens de glissement (18,19) de façon à faciliter les opérations de maintenance, ces moyens de glissement comportant par exemple au moins une glissière.

7. Système de connexion électrique selon la revendication 1 ou 4, caractérisé en ce qu'il comporte aussi des moyens de détrompage mécanique de façon à éviter que le boîtier soit monté d'une façon erronée.

8. Système de connexion électrique selon la revendication 1 ou 4, caractérisé en ce que le connecteur principal (9) est au standard de connexion du système informatique en distribution des signaux et en positions géométriques de façon à adapter tout type de périphérique au système informatique hôte.

9. Système de connexion électrique selon la revendication 1 ou 4, caractérisé en ce que le second des dits connecteurs secondaires est constitué par un connecteur pour fournir les signaux de commandes (4), et comprend en outre un troisième connecteur (5) pour l'alimentation.

## Patentansprüche

1. Elektrisches Verbindungssystem für Rechner zur lösbaren Anordnung eines Peripheriegerätes im Inneren des Rechners und zu dessen Verbindung mit dem Rechner über Stecker, dadurch gekennzeichnet, daß es aufweist:
- ein Gehäuse (2), das das eigentliche Peripheriegerät (1) enthält;
- einen ersten Stecker (9), der außen an dem Gehäuse an einer Position angebracht ist, die den Normen für die Verbindung der Peripheriegeräte mit den Hostrechnern genügt;
- wenigstens zwei Nebenstecker (3, 4, 5), die in einem Innenraum des Gehäuses untergebracht und mit dem ersten Stecker (9) elektrisch verbunden sind, wobei jeder Stecker eine bestimmte Funktion hat, wie die Verbindung der Datensignale oder die der Steuersignale des Peripheriegeräts, wobei diese Nebenstecker (3, 4, 5) mechanisch an Stellen befestigt werden können, die von den dem Peripheriegerät (1) eigenen Steckern abhängen, und wobei die Nebenstecker (3, 4, 5) mit dem Hauptstecker durch geschmeidige Drahtlitzen verbunden sind, deren Längen an die örtliche Lage der Stecker des in das Gehäuse eingefügten, integrierten Peripheriegeräts angepaßt sind.

2. Elektrisches Verbindungssystem nach Anspruch 1, dadurch gekennzeichnet, daß das Gehäuse Schutzmittel (12) gegen die elektromagnetischen Strahlen aufweist.

3. Elektrisches Verbindungssystem nach Anspruch 1 oder 2, dadurch gekennzeichnet, daß es Kühlmittel (11) für das integrierte Peripheriegerät aufweist.

4. Elektrisches Verbindungssystem nach Anspruch 1 oder 3, dadurch gekennzeichnet, daß das Gehäuse (2) aus zwei leitenden Hälften gebildet ist, die Öffnungen zum Kühlen der Geräte aufweisen, die es enthält, wobei jede Hälfte einen überlappenden Rand aufweist, ein Scharnier, das an der Rückseite des Gehäuses angeordnet ist, um eine der Hälften zur Unterbringung des Peripheriegeräts zu verschwenken.

5. Elektrisches Verbindungssystem nach Anspruch 1 oder 4, dadurch gekennzeichnet, daß es auch Greifmittel aufweist, um die Wartung des Informatiksystems zu erleichtern, wie einen Griff, der an der Vorderfläche des eingebauten Peripheriegeräts angeordnet ist.

6. Elektrisches Verbindungssystem nach Anspruch 1 oder 4, dadurch gekennzeichnet, daß es auch Gleitmittel (18, 19) aufweist, um die Wartungsoperationen zu erleichtern, wobei diese Gleitmittel beispielsweise wenigstens eine Gleitbahn aufweisen.

7. Elektrisches Verbindungssystem nach Anspruch 1 oder 4, dadurch gekennzeichnet, daß es auch mechanische Unverwechselbarkeitsmittel (18, 19) aufweist, um zu vermeiden, daß das Gehäuse fehlerhaft montiert wird.

8. Elektrisches Verbindungssystem nach Anspruch 1 oder 4, dadurch gekennzeichnet, daß der Hauptstecker (9) bezüglich der Verteilung der Signale und der geometrischen Positionen so auf dem Verbindungsstandard des Informatiksystems ist, daß jeder Typ von Peripheriegeräten an das Hostinformatiksystem angepaßt werden kann.

9. Elektrisches Verbindungssystem nach Anspruch 1 oder 4, dadurch gekennzeichnet, daß der zweite der Nebenstecker durch einen Stecker (4) zum Liefern der Steuersignale gebildet ist, und daß es außerdem einen dritten Stecker (5) für die Versorgung aufweist.

## Claims

1. An electrical connection system for a computer, with a view to disposing in a movable fashion a peripheral device inside the computer and linking it to the computer by connectors, characterised in that it comprises:
- a housing (2) which contains the peripheral device proper (1),
- a first connector (9) fixed externally to the housing in a position complying with the standards for connecting peripheral devices to host computers,
- at least two secondary connectors (3, 4, 5) housed in a space inside the housing and electrically connected to the first connector (9), each connector having a given function such as the connection of data signals or that of control signals for the peripheral device,
it being possible to fix these secondary connectors (3, 4, 5) mechanically at locations dependent on the connectors proper to the peripheral device (1), the secondary connectors (3, 4, 5) being linked to the principal connector by braids of flexible wires, the lengths of which are suited to the location of the connectors of the integral peripheral device inserted in the housing.

2. An electrical connection system according to Claim 1 characterised in that the housing comprises means for protection against electromagnetic radiation (12).

3. An electrical connection system according to Claim 1 or 2, characterised in that it comprises means (11) for cooling the integral peripheral device.

4. An electrical connection system according to Claim 1 or 3, characterised in that the housing (2) is formed of two conducting halves, comprising apertures for cooling the equipment it contains, each half having a covered edge, a hinge disposed on a rear panel of said housing to pivot one of said halves in order to mount the peripheral equipment.

5. An electrical connection system according to Claim 1 or 4, characterised in that it also comprises prehension means to facilitate maintenance of the computer system, such as a handle disposed on the front face of the peripheral device installed.

6. An electrical connection system according to Claim 1 or 4, characterised in that it also comprises sliding means (18, 19) to facilitate maintenance operations, these sliding means comprising for example at least one runner.

7. An electrical connection system according to Claim 1 or 4, characterised in that it also comprises mechanical locating means so as to prevent the housing from being mounted incorrectly.

8. An electrical connection system according to Claim 1 or 4, characterised in that the principal connector (9) is of the standard for connecting the computer system with distribution of signals and with geometric positions so as to make any type of peripheral suitable for the host computer system.

9. An electrical connection system according to Claim 1 or 4, characterised in that the second of said secondary connectors is composed of a connector to supply control signals (4), and further comprises a third connector (5) for the supply.
